Europäisches Patentamt

**European Patent Office**

**Office européen des brevets**

(19)

(11) Numéro de publication: **0 231 679**
**B1**

(12)

# FASCICULE DE BREVET EUROPEEN

(45) Date de publication du fascicule du brevet:
03.10.90

(51) Int. Cl.⁵: **H03G 3/20**, G01V 1/24

(21) Numéro de dépôt: **86402664.6**

(22) Date de dépôt: **02.12.86**

(54) **Dispositif pour amplifier et échantillonner des signaux à grande dynamique.**

(30) Priorité: **19.12.85 FR 8519100**

(43) Date de publication de la demande:
**12.08.87 Bulletin 87/33**

(45) Mention de la délivrance du brevet:
**03.10.90 Bulletin 90/40**

(84) Etats contractants désignés:
**BE DE GB IT NL**

(56) Documents cités:
**GB-A- 2 062 989**
**GB-A- 2 081 038**

(73) Titulaire: **INSTITUT FRANCAIS DU PETROLE, 4, Avenue de Bois-Préau, F-92502 Rueil-Malmaison(FR)**

(72) Inventeur: **Beauducel, Claude, 8, rue Talon, F-60119 Henonville(FR)**
Inventeur: **Fouquet, Pierre, 44, rue de l'Ermitage, F-95100 Argenteuil(FR)**

# Description

L'invention concerne un dispositif pour amplifier et échantillonner des signaux à grande dynamique.

Le dispositif, selon l'invention, est adapté en particulier à l'amplification et l'échantillonnage des signaux dans une chaîne d'acquisition de signaux, avant leur numérisation par un convertisseur analogique-numérique et leur enregistrement, et en particulier à l'amplification de signaux sismiques.

Les méthodes de prospection sismique comportent généralement l'émission d'ondes par une source sismique, la réception des ondes renvoyées par les différents interfaces réfléchissants du sous-sol et la réalisation d'enregistrements sismiques représentatifs de la configuration du sous-sol. La réception des ondes est effectuée par des dispositifs de réception comportant un très grand nombre de capteurs répartis le long du profil sismique à étudier. Pour la prospection sismique en mer, les capteurs sont répartis tout le long et à l'intérieur d'une gaine souple, étanche, de grande longueur que l'on appelle flûte sismique.

Dans les flûtes sismiques récentes, l'ensemble des capteurs est réparti en une pluralité de sous-ensembles. Les signaux captés par les capteurs d'un même sous-ensemble sont collectés par un appareil électronique d'acquisition de données qui les numérise et les enregistre. Après chaque cycle d'émission-réception, les signaux enregistrés par les différents appareils de la flûte sismique sont transmis à un laboratoire central de commande et d'enregistrement par l'intermédiaire d'un système de transmission multiplexée. Celui-ci comporte plusieurs lignes de transmission auxquelles se connectent par intermittence et séquentiellement les différents appareils, sur commande du laboratoire central. Un tel système de transmission est décrit par exemple dans le brevet français FR-A 2 471 088.

Pour obtenir un pouvoir de résolution de plus en plus grand, on est conduit à développer des flûtes sismiques de plus en plus longues, contenant un nombre accru de capteurs sismiques et par conséquent à augmenter parallèlement le nombre et la complexité des appareils d'acquisition utilisés pour collecter tous les signaux reçus. Les appareils d'acquisition sont disposés généralement dans des boitiers étanches intercalés entre des sections de la flûte, ces boitiers étant réunis au laboratoire central par des lignes de transmission de données, des lignes de transmission d'ordres et de signaux de test et aussi des lignes d'alimentation électrique.

L'augmentation de la capacité de collecte des appareils d'acquisition conduit à augmenter parallèlement le nombre de leurs modules électroniques. Ceci se traduit par une augmentation de volume des boitiers intercalés et de leur masse, et aussi par un accroissement important de leur consommation électrique. Il est donc souhaitable d'employer des appareils d'acquisition dont les différents modules électroniques sont optimisés pour concilier à la fois les performances, la fiabilité et une consommation électrique relativement basse. Cela est vrai notamment pour les chaînes d'amplification adaptées à porter l'amplitude des signaux reçus par les capteurs sismiques à un niveau suffisant pour pouvoir être appliqués à un convertisseur analogique-numérique.

Par les brevets FR-A 2 110 758 et FR-A 2 373 914, on connaît des agencements d'amplificateurs où les signaux captés sont appliqués aux entrées d'un multiplexeur analogique disposé en tête de la chaîne d'acquisition après une amplification préalable dans un préamplificateur à gain fixe. La sortie du multiplexeur est connectée à un amplificateur unique constitué par une chaîne d'éléments amplificateurs disposés en série, la sortie de chacun d'eux étant connectée à l'entrée du suivant. Le gain de chaque élément amplificateur est fixe et choisi de préférence égal à une puissance entière du nombre deux. Comme la variation d'amplitude de deux échantillons successifs quelconques peut être très grande, un organe de sélection choisit le nombre d'unités d'amplification que doit traverser chaque signal pour atteindre un niveau optimal et commute la sortie de l'élément amplificateur où ce signal est disponible sur l'entrée d'un convertisseur analogique-numérique, lequel est connecté à un système d'enregistrement.

Les échantillons successifs délivrés par le multiplexeur en tête sont mémorisés dans un échantillonneur-bloqueur disposé en amont de la chaîne d'amplification et qui opère de ce fait sur des signaux à grande dynamique. On sait que cette disposition présente des inconvénients: les échantillonneurs-bloqueurs couramment utilisés ont pour défaut d'introduire de la diaphonie entre les échantillons successifs. Les erreurs qui en résultent se trouvent amplifiées avec un gain égal au gain maximal de la chaîne d'amplification. En outre les amplificateurs-tampons que comportent les échantillonneurs-bloqueurs, généralement employés, viennent allonger encore la chaîne des étages d'amplification.

Par la demande de brevet GB-A 2 062 989 on connait un dispositif d'amplification et d'échantillonnage de signaux analogiques multiplexés comportant trois unités d'amplification et d'échantillonnage interconnectées comportant chacune un étage amplificateur dont la sortie est connectée à un échantillonneur-bloqueur disposé en dérivation. Le gain du premier étage est égal à 1. Les deuxième et troisième sont associés à des réseaux de contre-réaction et sont susceptibles de prendre sélectivement plusieurs valeurs de gain différentes prédéterminées par action d'un organe de sélection. Les tensions aux sorties du deuxième et du troisième étage sont comparées respectivement avec des tensions-seuils dans deux comparateurs de tension. Un cycle de sélection à deux étages impliquant une réamplification d'une des tensions mémorisées par un des échantillonneurs-bloqueurs, permet d'atteindre n'importe quelle valeur de gain dans une large fourchette.

Le dispositif selon l'invention permet d'amplifier et d'échantillonner des signaux à grande dynamique issus d'un multiplexeur avec une structure plus simple, en évitant les inconvénients ci-dessus mentionnés.

Le dispositif selon l'invention comporte une première et une seconde unités d'amplification et d'échantillonnage, chacune d'elles étant associée à un réseau de contre-réaction et susceptible de prendre sélectivement plusieurs valeurs de gain différentes par fermeture d'interrupteurs, des moyens de comparaison de tension pour comparer la valeur des signaux issus des deux unités d'amplification et d'échantillonnage avec des tensions-seuils, et des moyens de sélection des interrupteurs et des éléments de commutation, en fonction du signal issu du comparateur de tension, pour choisir le gain de chacune des unités d'amplification et d'échantillonnage et le nombre de passages des signaux à travers chacune d'elles et il est caractérisé en ce que chaque unité d'amplification et d'échantillonnage comporte un échantillonneur-bloqueur disposé en série, la sortie de l'échantillonneur-bloqueur de ladite première unité étant connectée en permanence à l'entrée de ladite seconde unité, ces échantillonneurs-bloqueurs pouvant prendre plusieurs valeurs de gain prédéterminées au moyen desdits réseaux de contre-réaction sur commande desdits moyens de sélection, et en ce que les éléments de commutation comportent un premier élément de commutation pour connecter sélectivement la sortie du premier ou du second desdits échantillonneurs-bloqueurs à l'entrée du comparateur de tension, et un second élément de commutation pour connecter sélectivement à l'entrée du premier échantillonneur-bloqueur, soit la tension issue du multiplexeur, soit la tension issue du second échantillonneur-bloqueur.

Les réseaux de contre-réaction sont choisis de préférence pour donner au premier échantillonneur-bloqueur un gain d'amplification de 1, 2 ou 16, et au second, un gain d'amplification de 2 ou 16.

Le dispositif, selon l'invention, présente de nombreux avantages. Deux échantillonneurs-bloqueurs à amplificateurs incorporés, interconnectées en série, suffisent à assurer toutes les fonctions d'échantillonnage-bloquage et d'amplification. Chacun d'eux est susceptible de prendre un nombre très limité de valeurs de gain différentes (2 ou 3 dans la pratique) et par conséquent les réseaux de contre-réaction nécessaires pour les obtenir sont réduits. Il s'agit donc là d'une structure simple et fiable moins onéreuse, à consommation électrique relativement faible qui permet cependant par un nombre limité d'étapes d'ajustement de gain et de réamplifications successives, d'obtenir une dynamique d'amplification très étendue. Un tel dispositif est bien adapté en particulier pour la réalisation de flûtes sismiques de très grande longueur utilisant de nombreuses chaines d'acquisition par la collecte des signaux captés par un très grand nombre de capteurs.

La dynamique des signaux mémorisés successivement par chaque unité d'échantillonnage-bloquage et d'amplification est beaucoup plus faible que dans le cas où cette fonction est remplie par un élément unique disposé en tête et par conséquent les effets parasites de diaphonie entre échantillons notés précédemment sont minimisés.

D'autres caractéristiques et avantages du dispositif apparaitront à la lecture de la description d'un mode de réalisation donné à titre d'exemple non limitatif, en se référant aux dessins annexés où:

— la figure 1 représente le schéma synoptique du dispositif;

— la figure 2 représente schématiquement l'organe de synchronisation qui coordonne le fonctionnement du dispositif;

- la figure 3 représente de façon synoptique l'agencement d'un échantillonneur-bloqueur pouvant être utilisé pour réaliser le dispositif ;

- les figures 4 et 5 représentent, à titre d'exemple, les chronogrammes de divers signaux de commande du dispositif, au cours de deux cycles d'amplification et d'échantillonnage de durées très inégales permettant d'appliquer à un signal d'entrée, dans le premier cas un gain de $2^{11}$, dans l'autre un gain de $2^{12}$ ;

- la figure 6 représente une partie du diagramme de sélection permettant d'appliquer à un signal d'entrée un gain au plus égal à $2^3$; et

- la figure 7 représente la partie complémentaire du diagramme de sélection, permettant d'appliquer à un signal d'entrée un gain compris entre $2^4$ et $2^{13}$.

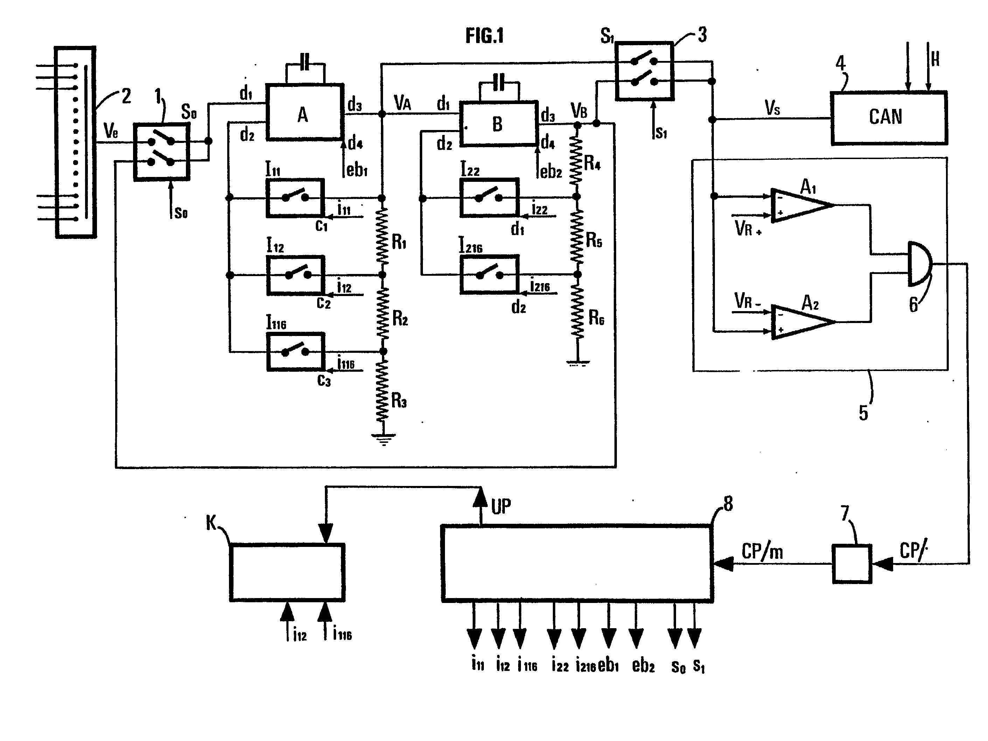

Le dispositif comporte (Fig. 1) un premier commutateur électronique $S_0(1)$ à deux voies. Une première entrée du commutateur $S_0$ reçoit d'un multiplexeur 2 un échantillon de signal $V_e$ à amplifier. Les deux sorties de commutateur $S_0$ sont connectées à une première entrée $d_1$ (entrée non inverseuse) d'un échantillonneur-bloqueur A. La sortie $d_3$ de celui-ci est connectée à la masse par trois résistances $R_1$, $R_2$, $R_3$, connectées en série. Une seconde entrée $d_2$ (entrée inverseuse) de l'échantillonneur-bloqueur A est connectée directement à la sortie $d_3$ par l'intermédiaire d'un premier interrupteur électronique $I_{11}$ d'un type connu, au point d'interconnexion des résistances $R_1$ et $R_2$, par l'intermédiaire d'un second interrupteur électronique $I_{12}$ et au point d'interconnexion des résistances $R_2$ et $R_3$ par l'intermédiaire d'un troisième interrupteur $I_{116}$. Sur une entrée de commande $d_4$ de l'échantillonneur-bloqueur A est appliqué un signal permettant alternativement l'échantillonnage et la mémorisation du signal appliqué à l'entrée. Les interrupteurs $I_{11}$, $I_{12}$ ou $I_{116}$ sont pourvus chacun d'une entrée de commande $c_1$, $c_2$, $c_3$ et sont fermés respectivement par application sur celles-ci de signaux $i_{11}$, $i_{12}$, $i_{116}$. Les trois résistances $R_1$, $R_2$, $R_3$ et les trois interrupteurs $I_{11}$, $I_{12}$, $I_{116}$ constituent un réseau classique de contre-réaction. Les valeurs des résistances sont choisies de manière que la fermeture sélective des interrupteurs $I_{11}$, $I_{12}$, $I_{116}$ donne à l'échantillonneur-bloqueur A, soit un gain unité, soit un gain de deux, soit un gain de seize. L'échantillonneur-bloqueur A avec son réseau de contre-réaction et les interrupteurs $I_{11}$, $I_{12}$, $I_{116}$ constituent la première unité d'amplification et d'échantillonnage.

La sortie $a_3$ de l'échantillonneur-bloqueur A est connectée à une première entrée $b_1$ (non inverseuse) d'un second échantillonneur-bloqueur B. La sortie $b_3$ de celui-ci est également connectée à la masse par l'intermédiaire de trois résistances $R_4$, $R_5$, $R_6$ connectées en série. Une seconde entrée $b_2$ (inverseuse) de l'échantillonneur-bloqueur B est connectée au point d'interconnexion des résistances $R_4$, $R_5$, par l'intermédiaire d'un quatrième inter-

rupteur $I_{22}$ et au point d'interconnexion des résistances $R_5$, $R_6$ par l'intermédiaire d'un cinquième interrupteur $I_{216}$. Les interrupteurs $I_{22}$, $I_{216}$ sont aussi pourvus d'une entrée de commande $d_1$, $d_2$ et sont fermés respectivement par application sur celles-ci de signaux $i_{22}$, $i_{216}$. De la même façon l'échantillonneur-bloqueur B comporte une entrée $d_4$ pour l'application d'un signal $eb_2$ de commande. Les trois résistances $R_4$, $R_5$, $R_6$ et les deux interrupteurs $I_{22}$, $I_{216}$ constituent également un réseau classique de contre-réaction. Les valeurs des trois résistances sont choisies de manière que la fermeture de l'interrupteur $I_{22}$ ou de l'interrupteur $I_{216}$ donne à l'échantillonneur B un gain égal à deux ou un gain égal à seize. L'échantillonneur-bloqueur B, le réseau de contre-réaction et les interrupteurs $I_{22}$, $I_{216}$ associés constituent la seconde unité d'amplification et d'échantillonnage.

La sortie $d_3$ du second échantillonneur-bloqueur B est connectée à la seconde entrée du commutateur $S_0(1)$. Les sorties respectives des deux échantillonneurs-bloqueurs A, B sont connectées aux deux entrées d'un commutateur à deux voies $S_1(3)$. Les sorties interconnectées du commutateur $S_1$ constituent la sortie du dispositif. Le signal $V_s$ qui y est disponible est appliqué à un convertisseur analogique-numérique 4 d'un type connu.

Les commutateurs $S_0$ et $S_1$ sont pourvus d'une entrée de commande. Leur fermeture est assurée par l'application sélective sur celles-ci de signaux de commande $s_0$, $s_1$.

Le signal $V_s$ disponible à la sortie du dispositif est appliqué à l'entrée d'un commutateur à seuils 5. Il est comparé à deux tensions de référence $V_{R+}$ $V_{R-}$ symétriques, l'une positive l'autre négative, par deux amplificateurs de comparaison $A_1$, $A_2$ dont les sorties sont connectées aux entrées respectives d'une porte ET6 à deux entrées. On désigne par CP/ le signal disponible à la sortie de la porte ET6. Suivant que la valeur absolue de l'amplitude du signal de sortie $V_s$ est inférieure à la tension de seuil $V_{R+}$ ou supérieure, le signal CP/sera égal à 1 ou 0. Le signal CP/ issu du comparateur à seuil 5 est appliqué à un élément de mémorisation 7. Les valeurs mémorisées CP/m du signal CP/ sont utilisées par un organe de synchronisation 8 qui élabore les différents signaux de commande. Différents signaux engendrés par l'organe de synchronisation 8, sont appliqués à un ensemble de mémorisation K des valeurs de gain, comme on le verra plus en détail ci-après.

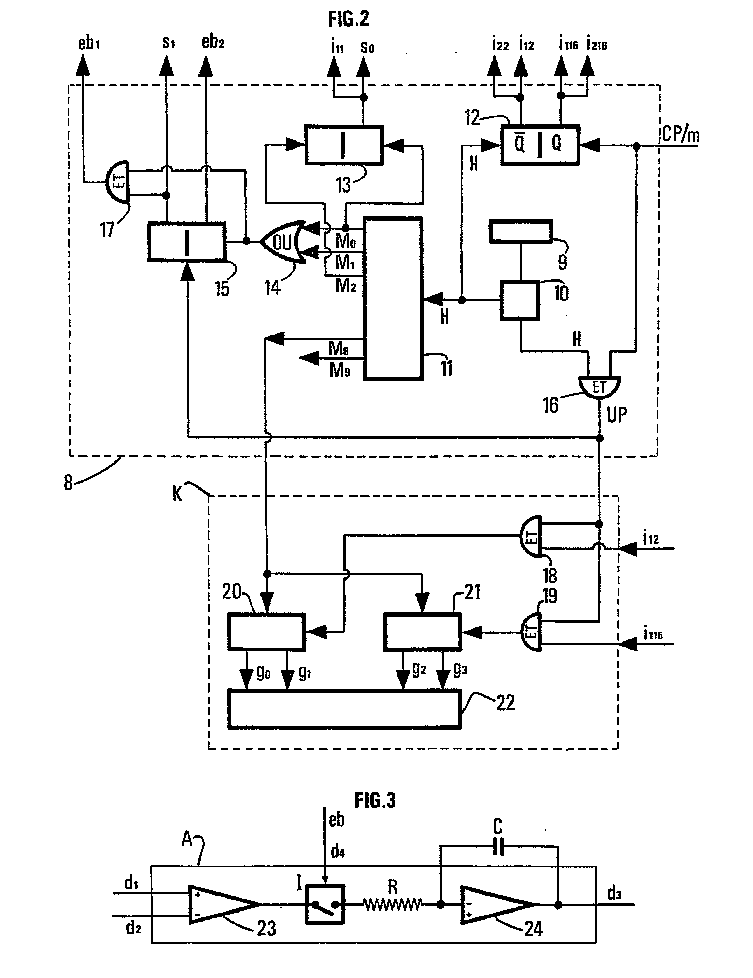

L'organe de synchronisation 8 comporte (Fig. 2) un oscillateur 9 générant un signal de référence dont la fréquence est divisée par un facteur déterminé, par un élément diviseur 10. Le signal d'horloge H engendré par le diviseur 10 est appliqué d'une part à un décodeur 11 qui délivre sur dix sorties, des signaux $M_0$ à $M_9$, définissant dix instants successifs séparés par des intervalles de temps égaux à la période du signal d'horloge H. Il est aussi appliqué à une première entrée d'un basculeur bistable 12 dont l'autre entrée reçoit le signal CP/m issu de l'élément de mémorisation 7. A la sortie Q du basculeur 12 sont disponibles deux signaux $i_{116}$, $i_{216}$ qui sont respectivement appliqués aux entrées de commande des interrupteurs $I_{116}$, $I_{216}$ (Fig. 1). A la sortie complémentaire Q du basculeur 12 sont disponibles deux signaux $i_{12}$, $i_{22}$ qui constituent les signaux de commande respectifs des interrupteurs $I_{12}$, $I_{22}$ (Fig. 1).

Les signaux $M_0$ et $M_2$ sont appliqués respectivement à deux entrées d'un second basculeur bistable 13. A la sortie Q de celui-ci est disponible un signal utilisé à la fois comme signal de commande $s_0$ du commutateur $S_0$ et comme signal de commande $i_{11}$ de l'interrupteur $I_{11}$ de l'échantillonneur-bloqueur A (Fig 1).

Les deux signaux successifs $M_0$, $M_1$ issus du décodeur 11 sont appliqués par l'intermédiaire d'une porte OU 14 à une première entrée d'un troisième basculeur bistable 15. Celui-ci reçoit sur son entrée "horloge" le signal UP délivré par une porte ET(16) à deux entrées, lesquelles entrées reçoivent respectivement le signal d'horloge H issu de l'élément diviseur 10 et le signal mémorisé CP/m. Sur une première borne de sortie du basculeur 15 est disponible un signal $s_1$ utilisé pour commander le commutateur $S_1$ (Fig. 1). Le signal $eb_2$ disponible sur la borne de sortie complémentaire, est appliqué à l'entrée $d_4$ de l'échantillonneur-bloqueur B (Fig. 1) ainsi qu'à une première entrée d'une porte ET 17. Sur une seconde entrée de celle-ci est appliqué le signal issu de la porte OU(14). A sa sortie est disponible un signal $eb_1$ qui est utilisé pour commander l'échantillonneur-bloqueur A (Fig. 1) sur son entrée $d_4$.

Les signaux $i_{12}$, $i_{116}$ délivrés par le basculeur 12 sont aussi appliqués respectivement à une première entrée de deux portes ET 18, 19. Sur une seconde entrée de celles-ci est appliqué le signal UP délivré par la porte 16. Les sorties des deux portes ET 18, 19 sont connectées aux entrées de comptage de deux compteurs 20, 21. L'entrée de commande de ces deux compteurs est connectée à la sortie du décodeur 11 où est disponible le signal $M_8$. L'application de ce signal inhibe le comptage. Les sorties $g_0$, $g_1$, $g_2$, $g_3$ de ces deux compteurs sont connectées aux entrées d'un élément de mémorisation du gain 22. Les valeurs de gain figées dans les compteurs 20, 21 à la fin de chaque cycle d'amplification et d'échantillonnage, quand le signal à amplifier a atteint un niveau optimal, sont ainsi mémorisées. Les portes 18, 19, les compteurs 20, 21 et l'élément de mémorisation 22, constituent l'ensemble de mémorisation de gain 9.

Les échantillonneurs-bloqueurs A et B sont identiques. Chacun d'eux comporte (Fig. 3) deux amplificateurs différentiels 23, 24. Le premier 23 est monté en boucle ouverte, le second 24, en intégrateur au moyen d'une résistance R et d'un condensateur C comme il est bien connu. La sortie du premier est connectée à l'entrée du second par l'intermédiaire d'un interrupteur I qui est actionné par application sur la borne $d_4$ d'un signal eb issu de l'organe de synchronisation 8. Les bornes $d_1$ et $d_3$ représentent respectivement l'entrée et la sortie de l'échantillonneur-bloqueur. Le réseau de contre-réaction associé à chaque échantillonneur-bloqueur A ou B (Fig. 1) est connecté entre la sortie du second amplificateur 24 et l'entrée inverseuse $d_2$ du premier amplificateur. Les échantillonneurs-bloqueurs utilisés se présentent sous la forme de circuits intégrés.

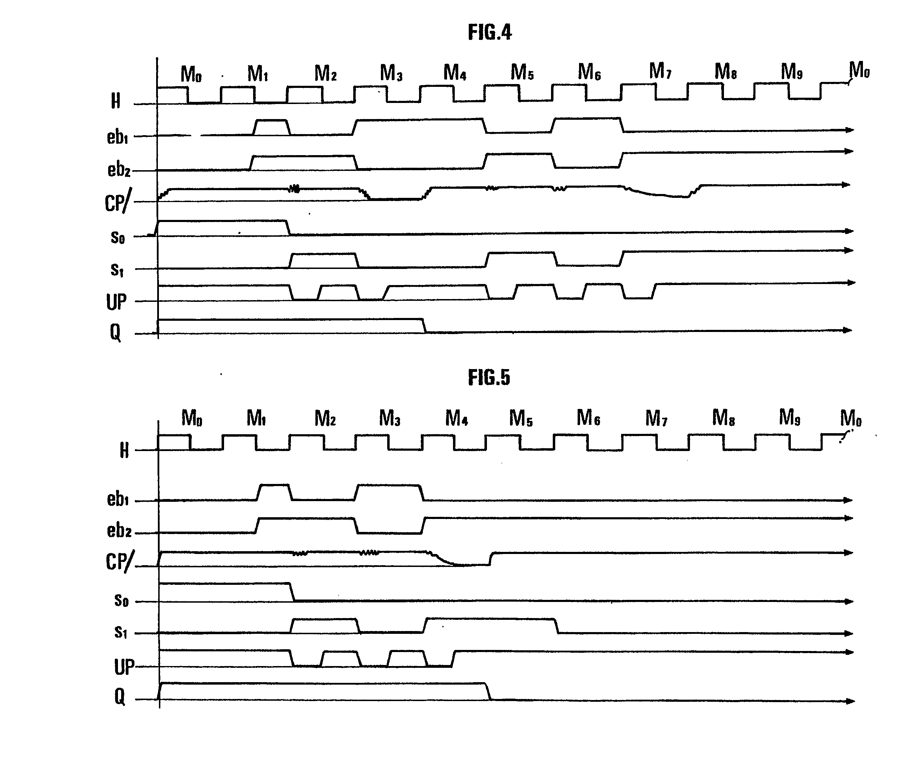

Le fonctionnement du dispositif d'amplification et d'échantillonnage est expliqué en détail par les diagrammes de sélection des figures 4, 5. Chaque cycle d'amplification comporte :
- une étape initiale $E_0$ d'échantillonnage où l'organe de synchronisation :

a) actionne les commutateurs $S_0$ et $S_1$ de manière que le signal $V_e$ issu du multiplexeur soit appliqué à l'entrée de l'échantillonneur-bloqueur A et que celui-ci issu du second B soit appliqué au comparateur 5 ;

b) commande l'application d'un gain de 1 et d'un gain de 16 respectivement aux échantillonneurs-bloqueurs A et B ;

c) actionne les interrupteurs I de manière que ceux-ci mémorisent dans leurs condensateurs C respectifs la valeur des signaux amplifiés ;

et ensuite :
- plusieurs étapes successives de comparaison des tensions aux sorties des deux échantillonneurs-bloqueurs A, B avec les valeurs-seuils, de modifications éventuelles des gains et, si le niveau d'amplification atteint n'est pas suffisant, de rebouclage de la sortie du second échantillonneur sur l'entrée du premier de manière à appliquer aux signaux une nouvelle amplification.

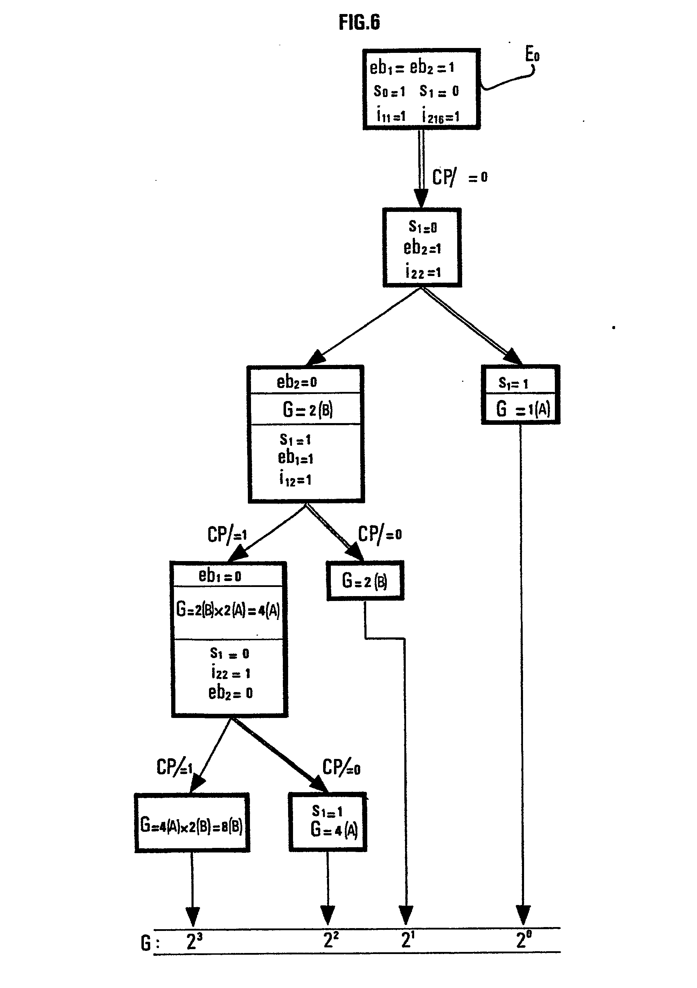

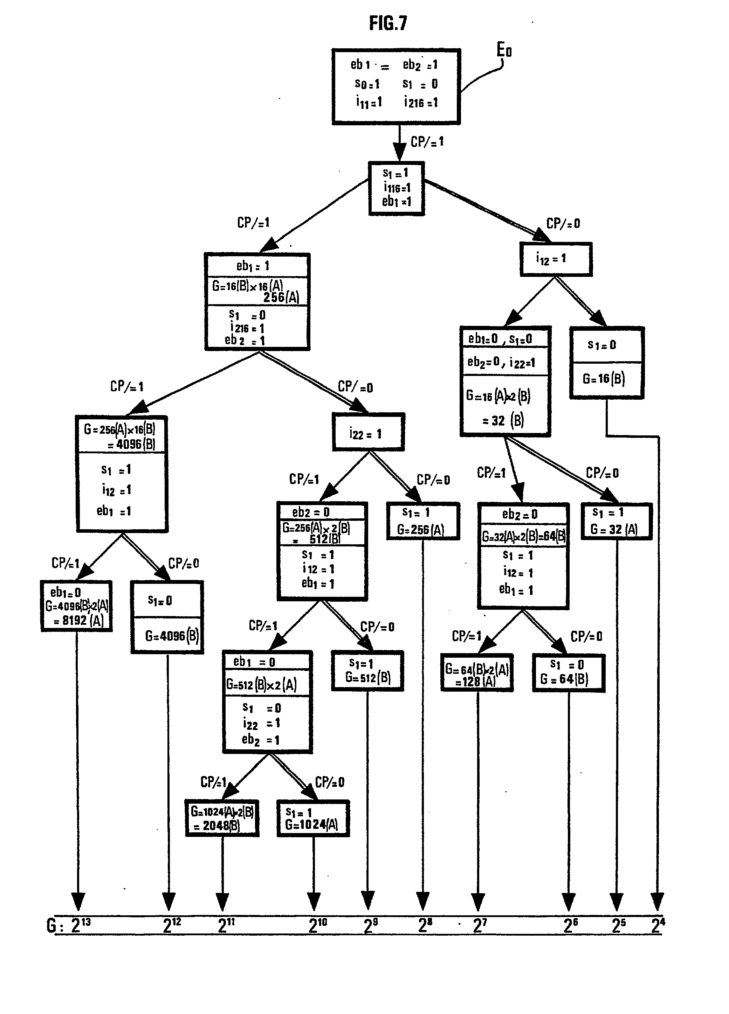

Si le signal issu du second échantillonneur-bloqueur est supérieur à la valeur-seuil et que par conséquent le signal CP/ prenne la valeur logique 0, le cycle de sélection se poursuit de la manière indiquée par le diagramme de la figure 6. Dans le cas contraire c'est celui de la figure 7 qui décrit la suite du cycle de sélection.

Pour des raisons de simplification, les diagrammes sont rédigés en utilisant les conventions suivantes :

a) Lorsque le signal $S_0$ a pour valeur logique 1, cela signifie que le signal $V_e$ à l'entrée du dispositif est appliqué à l'entrée $d_1$ du premier échantillonneur-bloqueur A. Si sa valeur logique est 0, c'est le signal $V_b$ à la sortie du second B qui est appliqué par rebouclage à cette même entrée $d_1$.

b) La valeur logique 1 attribuée au signal $s_1$ signifie que le signal $V_A$ issu du premier échantillonneur-bloqueur A est appliqué à l'entrée du comparateur 5. Si le signal $s_1$ a pour valeur logique 0, c'est le signal $V_B$ à la sortie du second B qui est appliqué au comparateur 5.

c) L'affectation aux signaux $i_{11}$, $i_{12}$, $i_{116}$, $i_{22}$, $i_{216}$, $eb_1$ et $eb_2$ de la valeur logique 1 signifie que les interrupteurs $I_{11}$, $I_{12}$, $I_{116}$, $I_{22}$, $I_{216}$ et les interrupteurs I (cf. Fig. 3) sont fermés. La valeur 0 affectée à ces mêmes signaux signifient, par convention, qu'ils sont ouverts.

d) Lorsqu'une valeur du gain G est suivie entre parenthèses de la lettre A ou B, cela signifie que le signal amplifié auquel ce gain est affecté est disponible à la sortie de l'échantillonneur-bloqueur correspondant. Lorsqu'elle s'exprime sous la forme d'un produit de deux nombres, l'un suivi de la lettre A, l'autre de la lettre B, cela signifie que le gain global résulte des contributions des deux échantillonneurs-bloqueurs, le premier gain partiel étant celui qui affecte le signal amplifié à la sortie du premier (A), le second gain partiel, celui qui affecte le signal à la sortie du second (B).

On voit sur les deux diagrammes des figures 6 et 7 que, selon le niveau du signal $V_e$ issu du multiplexeur, le cycle d'échantillonnage et d'amplification comporte, après l'étape initiale $E_0$, de deux à six étapes supplémentaires.

Sur les chronogrammes de la figure 4, on voit par exemple que le gain total de $2^{11}$ est atteint à l'instant $M_8$ du cycle par application au signal d'entrée par l'un ou l'autre des échantillonneurs-bloqueurs de 2 fois un gain de 16 et de 3 fois un gain de 2. Les chronogrammes de la figure 5 montrent aussi par exemple que l'on peut appliquer un gain de $2^{12}$ au signal d'entrée en l'amplifiant avec un gain de 16, une fois dans le premier échantillonneur-bloqueur A et deux fois avec ce même gain dans le second, le niveau optimal étant atteint à l'instant $M_5$ du cycle.

A l'issue de chaque cycle d'une durée égale à 10 périodes du signal d'horloge H, un nouveau cycle recommence pour un autre échantillon de signal $V_e$ appliqué à l'entrée.

**Revendications**

1. Dispositif pour amplifier et échantillonner des signaux à grande dynamique, issus d'un multiplexeur (2) comportant une première et une seconde unités d'amplification et d'échantillonnage, chacune d'elles étant associée à un réseau de contre-réaction (R1-R6) et susceptible de prendre sélectivement plusieurs valeurs de gain différentes par fermeture d'interrupteurs ($I_{11}$–$I_{116}$, $I_{12}$–$I_{216}$), des moyens de comparaison de tension (5) pour comparer la valeur des signaux issus des deux unités d'amplification et d'échantillonnage avec des tensions-seuils ($V_R$), et des moyens de sélection (7, 8) des interrupteurs et des éléments de commutation, en fonction du signal issu du comparateur de tension (2), pour choisir le gain de chacune des unités d'amplification et d'échantillonnage et le nombre de passages des signaux à travers chacune d'elles, caractérisé en ce que chaque unité d'amplification et d'échantillonnage comporte un échantillonneur-bloqueur (A, B) disposé en série, la sortie de l'échantillonneur-bloqueur de ladite première unité (A) étant connectée en permanence à l'entrée de ladite seconde unité (B), ces échantillonneurs-bloqueurs pouvant prendre plusieurs valeurs de gain prédéterminées au moyen desdits réseaux de contre-réaction sur commande desdits moyens de sélection (7, 8), et en ce que les éléments de commutation comportent un premier élément de commutation ($S_1$) pour connecter sélectivement la sortie du premier ou du second desdits échantillonneurs-bloqueurs (A, B) à l'entrée du comparateur de tension (5), et un second élément de commutation ($S_0$) pour connecter sélectivement à l'entrée du premier échantillonneur-bloqueur (A), soit la tension issue du multiplexeur (2), soit la tension issue du second échantillonneur-bloqueur (B).

2. Dispositif selon la revendication 1, caractérisé en ce que les résistances électriques (R₁–R₃) du réseau de contre-réaction associé au premier échantillonneur-bloqueur (A) sont choisies pour donner à celui-ci un gain d'amplification de 1, 2 ou 16 et en ce que celles (R₄–R₆) du réseau de contre-réaction associé au second échantillonneur-bloqueur (B) sont choisies pour lui donner un gain d'amplification de 2 ou 16.

3. - Dispositif selon la revendication 2, caractérisé en ce que les moyens de sélection des interrupteurs et des moyens de commutation comportent des moyens (9, 10) pour engendrer un signal d'horloge, un décodeur (11) pour engendrer des signaux définissant des instants successifs (M₀ à M₉) d'un même cycle d'amplification, un premier basculeur bistable (12) actionné par le signal d'horloge et le signal issu du comparateur de tension (5), pour engendrer des signaux de commande des interrupteurs (I₁₂, I₂₂, I₁₁₆, I₂₁₆) des réseaux de contre-réaction associés aux deux échantillonneurs-bloqueurs (A, B), un second basculeur bistable (13) actionné par deux signaux (M₀, M₂) issus du décodeur (11) et définissant deux instants d'un même cycle d'amplification, pour engendrer un signal de commande du second commutateur (S₀) et d'un interrupteur (I₁₁) du réseau de contre-réaction associé au premier échantillonneur-bloqueur (A), un troisième basculeur bistable (15) actionné soit par deux signaux (M₀, M₁) issu du décodeur (11) et définissant les deux premiers instants consécutifs d'un même cycle d'amplification, soit par un signal (UP) dérivé du signal d'horloge et du signal (CP/) issu du comparateur de tension, pour engendrer un signal (s₁) pour la commande du premier commutateur (S₁), un signal pour commander le second échantillonneur-bloqueur (B) et un signal (eb₁) conditionné par les deux signaux (M₀, M₁) issus du décodeur (11) et définissant les deux premiers instants du cycle d'amplification, pour la commande du premier échantillonneur-bloqueur (A).

4. - Dispositif selon la revendication 3, caractérisé en ce que les moyens de sélection des interrupteurs et des éléments de commutation comportent un ensemble (K) de mémorisation de la valeur prise par le gain à la fin de chaque cycle d'amplification, cet ensemble comportant des compteurs (20, 21) pour comptabiliser les signaux issus du premier basculeur bistable (12), l'entrée de validation des compteurs étant connectée à une sortie du décodeur (11), leurs sorties étant connectées à un élément de mémorisation (22) de la valeur du gain.

## Claims

1. Device to amplify and sample signals at a high dynamic level, originating from a multiplexor (2), comprising a first set and a second set of amplification and sampling units, each unit being associated with a feedback circuit (R₁–R₆) and capable of selectively achieving several different gain values by closing switches (I₁₁–I₁₁₆, I₁₂–I₂₁₆), a voltage comparison device (5) for comparing the value of the signals originating from the two amplification and sampling units with the voltage thresholds (V_R) and a selection device (7, 8) for the switches and the switching devices, depending on the signal from the voltage comparator (2), in order to select the gain for each of the amplification and sampling units and the number of times the signals pass through each unit, characterised in that each amplification and sampling unit includes a sample-and-hold unit (A, B), arranged in series, the output of the sample-and-hold unit for the said first unit (A) being permanently connected to the input of the said second unit (B), these sample-and-hold units being capable of achieving several predetermined gain values by means of the said feedback circuits, when controlled by the said selection devices (7, 8) and in that the switching devices include a first switching device (S₁) for selectively connecting the output of the first or the second of the said sample-and-hold units (A, B) to the input of the voltage comparator (5) and a second switching device (S₀) for selectively connecting to the input of the first sample-and-hold unit (A) either the voltage originating from the multiplexor (2) or the voltage originating from the seond sample-and hold unit (B).

2. Device in accordance with claim 1, characterised in that the electrical resistances (R₁–R₃) for the feedback circuit associated with the first sample-and-hold unit (A) are selected to provide it with an amplification gain of 1, 2 or 16 and in that those of the resistances (R₄–R₆) for the feedback circuit associated with the second sample-and-hold unit (B) are selected so that they provide an amplification gain of 2 or 16.

3. Device in accordance with claim 2, characterised in that the selection device for the switches and the switching devices include a device (9, 10) to generate a clock signal, a decoder (11) to generate signals defining the successive instants (M₀ to M₉) of the same amplification cycle, a first bistable trigger circuit (12) operated by the clock signal and the signal originating from the voltage comparator (5) in order to generate signals for controlling the switches (I₁₂, I₂₂, I₁₁₆, I₂₁₆) for the feedback circuits associated with the two sample-and-hold units (A, B), a second bistable trigger circuit (13) operated by two signals (M₀, M₂) originating from the decoder (11) and defining two instants within the same amplification cycle in order to generate a signal for controlling the second switch (S₀) and a switch (I₁₁) for the feedback circuit associated with the first sample-and-hold unit (A), a third bistable trigger circuit (15) operated either by two signals (M₀, M₁) from the decoder (11) and defining the first two consecutive instants of the same amplification cycle, or by using a signal (UP) derived from the clock signal and the signal (CP/) from the voltage comparator, in order to generate a signal (s₁) for controlling the first switch (S₁), a signal for controlling the second sample-and-hold unit (B) and a signal (eb₁) which is determined by the two signals (M₀, M₁) from the decoder (11) and defining the first two instants of the amplification cycle, in order to control the first sample-and-hold unit (A).

4. Device in accordance with claim 3, characterised in that the selection device for the switches and the switching devices comprises a unit (K) for storing the gain value achieved on completion of each amplification cycle, this unit including counters (20, 21) in order to identify and count the signals originating from the first bistable trigger circuit (12), the validation input for the counters being connected to an output of the decoder (11), their outputs being connected to a device (22) for storing the value of the said gain.

## Patentansprüche

1. Einrichtung zum Verstärken und Abtasten von aus einem Multiplexer (1) austretenden Signalen großer Dynamik mit einer ersten und einer zweiten Verstärkungs- und Abtasteinheit, von denen jede einem Gegenkopplungs-Netzwerk (R₁-R₆) zugeordnet und dazu geeignet ist, selektiv mehrere unterschiedliche Verstärkungswerte durch Schließen von Schaltern ($I_{11}$-$I_{116}$, $I_{12}$-$I_{216}$) anzunehmen, mit Spannungsvergleichsmitteln (5) zum Vergleichen des Wertes der Ausgangssignale der beiden Verstärkungs- und Abtasteinheiten mit Schwellenwertspannungen ($V_R$) und mit Mitteln (7, 8) zur Auswahl von Schaltern und Umschaltelementen in Abhängigkeit vom Ausgangssignal des Spannungsvergleichers (5) zur Wahl der Verstärkung jeder der Verstärkungs- und Abtasteinheiten und der Zahl der Signaldurchgänge durch jede von ihnen, dadurch gekennzeichnet, daß jede Verstärkungs- und Abtasteinheit eine in Reihe geschaltete Abtast- und Halteschaltung (A, B) aufweist, wobei der Ausgang der Abtast- und Halteschaltung der genannten ersten Einheit (A) fortwährend mit dem Eingang der genannten zweiten Einheit (B) verbunden ist und diese Abtast- und Halteschaltungen mehrere vorbestimmte Verstärkungswerte mittels der genannten Gegenkopplungs-Netzwerke aufgrund Steuerung der erwähnten Auswahlmittel (7, 8) annehmen können, und daß die Umschaltelemente ein erstes Umschaltelement (S₁) zum selektiven Verbinden des Ausgangs der ersten oder der zweiten der genannten Abtast- und Halteschaltungen (A, B) mit dem Eingang des Spannungsvergleichers (5) und ein zweites Umschaltelement (S₀) zum selektiven Verbinden entweder der Ausgangsspannung des Multiplexers (2) oder der Ausgangsspannung der zweiten Abtast- und Halteschaltung (B) mit dem Eingang der ersten Abtast- und Halteschaltung (A) aufweisen.

2. Einrichtung nach Anspruch 1, dadurch gekennzeichnet, daß die elektrischen Widerstände (R₁-R₃) des der ersten Abtast- und Halteschaltung (A) zugeordneten Gegenkopplungs-Netzwerkes so gewählt sind, daß ihr ein Verstärkungsgrad von 1, 2 oder 16 gegeben wird, und daß diejenigen (R₄-R₆) des der zweiten Abtast- und Halteschaltung (B) zugeordneten Gegenkopplungs-Netzwerkes so gewählt sind, daß ihr ein Verstärkungsgrad von 2 oder 16 gegeben ist.

3. Einrichtung nach Anspruch 2, dadurch gekennzeichnet, daß die Mittel zur Auswahl der Schalter und der Umschaltmittel Mittel (9, 10) zur Erzeugung eines Taktsignals, einen Decodierer (11) zur Erzeugung von Signalen, die aufeinanderfolgende Augenblicke (M₀ bis M₉) eines gleichen Verstärkungszyklusses definieren, eine erste, vom Taktsignal und Ausgangssignal des Spannungsvergleichers (5) betätigte bistabile Kippstufe (12) zur Bildung von Steuersignalen der Schalter ($I_{12}$, $I_{22}$, $I_{116}$, $I_{216}$) der den beiden Abtast- und Halteschaltungen (A, B) zugeordneten Gegenkopplungs-Netzwerken, eine zweite, durch zwei Augenblicke eines gleichen Verstärkungszyklusses definierende Ausgangssignale (M₀, M₂) des Decodierers (11) betätigte bistabile Kippstufe (13) zur Bildung eines Steuersignals des zweiten Umschalters (S₀) und eines Schalters ($I_{11}$) des der ersten Abtast- und Halteschaltung (A) zugeordneten Gegenkopplungs-Netzwerkes, eine dritte, entweder durch zwei die beiden ersten aufeinanderfolgenden Augenblicke eines gleichen Verstärkungszyklusses definierenden Ausgangssignale (M₀, M₁) des Decodierers (11) oder durch ein vom Taktsignal und vom Ausgangssignal des Spannungsvergleichers abgeleitetes Signal (CP/) betätigte bistabile Kippstufe (15) zur Bildung eines Signals (s₁) zur Steuerung des ersten Umschalters (S₁), eines Signals zur Steuerung der zweiten Abtast- und Halteschaltung (B) und eines durch die zwei die beiden ersten Augenblicke eines Verstärkungszyklusses definierenden Ausgangssignale (M₀, M₁) des Decodierers (11) beschafften Signals (eb₁) zur Steuerung der ersten Abtast- und Halteschaltung (A) aufweisen.

4. Einrichtung nach Anspruch 3, dadurch gekennzeichnet, daß die Mittel zur Auswahl der Schalter und der Umschaltelemente eine Baugruppe (K) zum Speichern des Werts der am Ende jedes Verstärkungszyklusses angenommenen Verstärkung aufweisen, wobei diese Baugruppe Zähler (20, 21) zur Rechnungsführung der Ausgangssignale der ersten bistabilen Kippstufe (12) aufweist, der Gültigerklärungseingang der Zähler mit einem Ausgang des Decodierers (11) verbunden ist und deren Ausgänge an ein Speicherungselement (22) des Verstärkungswertes angeschlossen sind.

FIG.1

**FIG.2**

**FIG.3**

EP 0 231 679 B1

## FIG.4

## FIG.5

## FIG.6

$E_0$

$eb_1 = eb_2 = 1$
$S_0 = 1 \quad S_1 = 0$
$i_{11} = 1 \quad i_{216} = 1$

$CP/ = 0$

$S_1 = 0$
$eb_2 = 1$
$i_{22} = 1$

$eb_2 = 0$

$G = 2(B)$

$S_1 = 1$
$eb_1 = 1$
$i_{12} = 1$

$S_1 = 1$

$G = 1(A)$

$CP/ = 1$

$CP/ = 0$

$eb_1 = 0$

$G = 2(B) \times 2(A) = 4(A)$

$S_1 = 0$
$i_{22} = 1$
$eb_2 = 0$

$G = 2(B)$

$CP/ = 1$

$CP/ = 0$

$G = 4(A) \times 2(B) = 8(B)$

$S_1 = 1$
$G = 4(A)$

$G: \quad 2^3 \qquad\qquad 2^2 \qquad 2^1 \qquad\qquad 2^0$

EP 0 231 679 B1

**FIG.7**